# EUROPÄISCHE PATENTANMELDUNG

(11) **EP 1 803 548 A1**
(43) Veröffentlichungstag der Anmeldung: **04.07.2007**
(21) Anmeldenummer: 05028697.0
(22) Anmeldetag: 30.12.2005
(51) Int. Cl.: B30B 15/06, B30B 15/34, B27N 3/20

(54) **Heizplatte für eine Plattenpresse**

(71) Anmelder: Robert Bürkle GmbH, 72250 Freudenstadt (DE)
(72) Erfinder: Damm, Norbert, 76689 Karlsdorf-Neuthard (DE); Dölker, Gerard, 72270 Baiersbronn (DE); Haist, Markus, 72250 Freudenstadt (DE)
(74) Vertreter: Kaiser, Magnus

(57) **Zusammenfassung**

Die Erfindung betrifft eine Heizplatte für eine Plattenpresse zum flächigen Verpressen von tafelförmigen Werkstücken mittels Druck und Wärme, bestehend aus mindestens zwei, an einer im Wesentlichen parallel zur Heizplattenebene verlaufenden Trennebene 3 fest miteinander verbundenen Teilplatten 1, 2, wobei im Inneren der Heizplatte eine Anzahl von Kanälen 4 vorgesehen ist, die entlang der Trennebene 3 zwischen den Teilplatten 1, 2 verlaufen und mit einem jeweils nach außen führenden Vorlaufkanal 8 sowie einem Rücklaufkarial 9 verbunden sind. Die Teilplatten 1,2 sind an ihren an die Trennebene 3 angrenzenden Oberflächen jeweils mit einer Anzahl von teilweise hinterschnittenen Nuten 6, 7 versehen, in welche mindestens je ein Verbinder 5 eingesetzt ist, der den Hinterschneidungen 10 der Nuten 6, 7 entsprechende Verbreiterungen zum Hintergreifen der Hinterschneidungen 10 aufweist.

## Beschreibung

Die Erfindung betrifft eine Heizplatte für eine Plattenpresse zum flächigen Verpressen von tafelförmigen Werkstücken mittels Druck und Wärme nach dem Oberbegriff des Anspruchs 1. Demnach besteht eine solche Heizplatte aus mindestens zwei, an einer im Wesentlichen parallel zur Heizplattenebene verlaufenden Trennebene fest miteinander verbundenen Teilplatten. Im Inneren der Heizplatte ist eine Anzahl von Kanälen vorgesehen, die entlang der Trennebene zwischen den Teilplatten verlaufen und mit einem jeweils nach außen führenden Vorlaufkanal sowie einem Rücklaufkanal verbunden sind. Der Begriff "Heizplatte" schließt nicht aus, dass die Heizplatte im Rahmen der vorliegenden Erfindung auch oder ausschließlich zum Kühlen eingesetzt wird.

Plattenpressen mit solchen Heizplatten werden zur Herstellung von Spanplatten, Faserplatten oder Sperrholzplatten verwendet, oder um solche Platten ein- oder beidseitig mit Vergütungsfolien oder Furnieren zu beschichten. Auch zur Herstellung von Chipkarten, elektrischen Leiterplatten sowie ganz allgemein zum Laminieren oder Heißprägen ein- oder mehrlagiger tafelförmiger Werkstücke werden Plattenpressen mit Heizplatten verwendet. Die Heizplatten übertragen die zur Verformung oder zur Aktivierung thermisch reagierender Kleber erforderliche Prozesswärme in möglichst kurzer Zeit und mit ausreichend gleichmäßiger flächiger Temperaturverteilung auf die Werkstücke. Umgekehrt können sie auch Kälte auf die Werkstücke übertragen. Gleichzeitig üben sie einen flächig wirkenden Druck auf die Werkstücke aus.

Zur Erzielung einer möglichst raschen homogenen Temperaturverteilung werden Heizplatten mit einer Anzahl von in ihrem Inneren verlaufenden Kanälen zur Durchleitung eines Fluids, insbesondere einer Flüssigkeit, beispielsweise Thermoöl versehen. Herkömmlicherweise werden diese Kanäle durch Langlochbohrungen in den massiv ausgebildeten Heizplatten hergestellt, die an ihren Enden durch Stopfen verschlossen werden. Das Anfertigen einer solchen herkömmlichen Heizplatte ist allerdings sehr kostenintensiv, insbesondere weil sehr lange Bohrungen gesetzt werden müssen, meist in der Größenordnung von einem Meter Länge und darüber. Ferner kann eine herkömmliche Heizplatte aufgrund der Langlochbohrungen eine gewisse Mindestdicke nicht unterschreiten, die in der Größenordnung von 35 mm liegt. Massive Heizplatten mit dieser Dicke besitzen allerdings eine erhebliche Wärmekapazität, so dass der Energieaufwand für das Aufheizen und Abkühlen der Heizplatten sehr hoch ist.

Zur Vermeidung dieser Nachteile ist aus der DE 203 01 292 U1 der Anmelderin eine Heizplatte der eingangs genannten Art bekannt geworden, bei der die Fluidkanäle nicht mehr durch Langlochbohrungen im Vollmaterial hergestellt werden, sondern durch Oberflächenfräsen auf einer Teilplatte. Die Heizplatte wird aus mindestens zwei Teilplatten zusammengesetzt, wobei die Kanäle für das durchgeleitete Fluid, insbesondere ein Thermoöl, in die Trennebene zwischen den beiden Teilplatten gelegt werden. So ist es möglich, entweder den gesamten Kanalquerschnitt der Kanäle aus einer der beiden Teilplatten auszufräsen, oder aus beiden Teilplatten jeweils einen Teilquerschnitt der Kanäle auszufräsen, wobei die Kanäle durch Aufeinandersetzen der beiden Teilplatten geschlossen werden. Wenn mehrere Kanalebenen vorgesehen sein sollen, können auch mehr als zwei Teilplatten verwendet werden, um die Heizplatte zusammenzusetzen.

Problematisch bei einer solchen aus Teilplatten bestehenden Heizplatte ist die feste Verbindung zweier Teilplatten an ihrer Trennebene. Denn das insbesondere aus einer Flüssigkeit bestehende Fluid, das durch die Kanäle geleitet wird, muss mit einem relativ hohen Pumpendruck beaufschlagt werden, um die zur schnellen Aufheizung und Abkühlung benötigte hohe Durchflussgeschwindigkeit durch die meist großflächigen Heizplatten zu gewährleisten. Ein hoher Pumpendruck führt jedoch zu einer sehr hohen auf die Teilplatten wirkenden Kraft in Richtung der Normalen der Trennebene, zumal dann, wenn die Flüssigkeit in den in der Trennebene gebildeten Spalt in den Kanalwänden eindringt und sich dementsprechend nahezu ganzflächig in der Trennebene innerhalb der Heizplatte verteilt. Denn die Teilplatten der Heizplatte sind im Wesentlichen nur an ihrem Umfang miteinander verschweißt.

Dementsprechend ist in der DE 203 01 292 U1 vorgeschlagen worden, zwischen den einzelnen Kanälen über die Fläche verteilt Zuganker in die Heizplatte einzusetzen, die die beiden beteiligten Teilplatten formschlüssig aneinander festlegen. Trotzdem diese Zuganker zwischen den Kanälen angeordnet sind, bilden sie dennoch eine problematische Durchbrechung der Teilplatten, da deren Sitz die Trennebene mit der Außenseite der Heizplatte verbindet. Es besteht hierdurch die Gefahr, dass das in der Trennebene zwischen den Kanälen befindliche Fluid durch die für die Zuganker gesetzte Bohrung nach außen an die Oberfläche der Heizplatte treten kann. Dementsprechend sind aufwendige Abdichtungsmaßnahmen an den Zugankerbohrungen und an den Zugankern selbst notwendig.

Ausgehend von diesem Stand der Technik liegt der vorliegenden Erfindung die Aufgabe zugrunde, bei Heizplatten der eingangs genannten Art die sichere Befestigung der Teilplatten aneinander zu verbessern.

Gelöst ist diese Aufgabe durch eine Heizplatte mit den Merkmalen des Anspruchs 1. Bevorzugte Ausgestaltungen der erfindungsgemäßen Heizplatte finden sich in den Ansprüchen 2 bis 6.

Gemäß der vorliegenden Erfindung werden also die aus dem Stand der Technik bekannten Zuganker durch Verbinder ersetzt, die in teilweise hinterschnittenen Nuten in den Teilplatten sitzen, welche an deren an die Trennebene angrenzenden Oberflächen eingebracht sind. Die Verbinder besitzen Verbreiterungen, die den Hinterschneidungen der Nuten entsprechen und diese Hinterschneidungen hintergreifen. Sie können hierzu im Querschnitt beispielsweise in Doppel-T-Form oder in doppelter Schwalbenschwanzform ausgebildet sein. Auch eine Kombination dieser beiden Formen oder andere Formen sind möglich. Im Übrigen können die Verbinder eine Längsachse aufweisen oder auch als Rotationskörper ausgebildet sein. In jedem Fall sitzen sie einerseits in der einen Teilplatte und andererseits in der anderen Teilplatte, hintergreifen die jeweiligen Hinterschneidungen der jeweiligen Nuten und sorgen so für eine formschlüssige. Verbindung der beiden Teilplatten untereinander, und zwar, nach Aufeinandersetzen der beiden Teilplatten, ohne irgendeine Verbindung nach außen. Ein Eindringen des durch die Heizplatte geleiteten Fluids über einen etwa entstehenden Spalt entlang der Trennebene in die Nuten der erfindungsgemäßen Verbinder ist daher völlig unkritisch.

Eingebracht werden die erfindungsgemäßen Verbinder in die Heizplatte vorzugsweise so, dass die Nuten in der einen Teilplatte in Längsrichtung gegen die Nuten in der anderen Teilplatte verschoben sind, wobei der Teil der Nuten, der hinterschhitten ist, bei lagerichtig aufeinandergesetzten Teilplatten übereinander zu liegen kommt, während derjenige Teil der Nuten, der keine Hinterschneidung aufweist, dann gegeneinander versetzt angeordnet ist. Dementsprechend können die Verbinder zunächst in eine Teilplatte eingesetzt werden, worauf die andere Teilplatte in Längsrichtung der Nuten versetzt auf die eine Teilplatte aufgesetzt und dann entlang der Längsrichtung der Nuten verschoben wird, um zu ermöglichen, dass die Verbinder an denjenigen Stellen, an denen die Nuten keine Hinterschneidung aufweisen, in die Nuten eingeführt werden und nach Verschieben der beiden Teilplatten gegeneinander, bis sie deckungsgleich aufeinanderliegen, dann beidseits die Hinterschneidungen der Nuten hintergreifen. Danach können die beiden Teilplatten beispielsweise randseitig umlaufend miteinander verschweißt werden.

Vorzugsweise bestehen die Verbinder aus demselben Material wie die Teilplatten, in denen sie montiert werden, insbesondere aus Stahl. Dies hat den Vorteil, dass die Verbinder denselben Wärmeausdehnungskoeffizienten besitzen, wie das Material, in dem sie sitzen, so dass keine Verspannungen durch Erwärmen und Abkühlen der Heizplatten zu befürchten sind.

Die Verbinder können zumindest teilweise klemmend in den Nuten sitzen, so dass sie eine feste formschlüssige Befestigung der beiden beteiligten Teilplatten aufeinander sicherstellen.

Alternativ können die Verbinder jedoch auch so in den Nuten sitzen, dass sie ein im Wesentlichen senkrecht zur Heizplattenebene wirksames Spiel aufweisen. In diesem Fall bilden die erfindungsgemäßen Verbinder lediglich eine Sicherung gegen ein Nachgeben der Teilplatten aufgrund eines durch Thermoflüssigkeit hergestellten Spaltdruckes in der Trennebene.

Den Effekt eines solchen Nachgebens der Teilplatten kann man allerdings auch bewusst nutzen:

Für bestimmte Anwendungen, insbesondere für das Verpressen von Leiterplatten, bietet es große Vorteile, wenn die wirksame Oberfläche der Heizplatte konvex ausgewölbt ist. Denn aufgrund der unterschiedlichen Wärmeausdehnungskoeffizienten des Leiterplatten-Grundmaterials und der darauf aufgebrachten Metallisierung bilden sich nachteilige Falten beim Verpressen mit absolut planen Heizplatten. Dies kann - wie erfindungsgemäß erkannt wurde - vermieden werden, wenn konvexe Heizplatten verwendet werden, die die Wärme und den Druck zunächst auf den zentralen Bereich der Leiterplatte aufbringen und Wärme sowie Druck dann nachfolgend konzentrisch nach außen fortsetzen.

Eine erfindungsgemäß ausgebildete Heizplatte kann nun, wie bisher an sich bekannt, so aus den Teilplatten zusammengesetzt werden, dass diese lediglich außen umlaufend miteinander stoffschlüssig verbunden, insbesondere verschweißt werden. Im Inneren der Heizplatte wird sodann der Effekt genutzt, dass die durch die Kanäle in der Trennebene geleitete Flüssigkeit auch zwischen den Kanälen in die Trennebene zwischen den beiden beteiligten Teilplatten gelangt und dort aufgrund der hohen Fläche der Heizplatte und dem herrschenden Pumpendruck für eine Kraft in der Flächennormalen sorgt, welche die beiden beteiligten Teilplatten auseinanderdrückt und für eine konvexe Verformung derselben sorgt. Die erfindungsgemäßen Verbinder können nun mit unterschiedlichen, in der Heizplattennormalen wirksamen Spiel versehen werden, und zwar derart, dass im Randbereich der Heizplatte kaum Spiel vorhanden ist, während zum Zentrum der Heizplatte hin das Spiel größer wird, so dass eine konvexe Verformung der beiden beteiligten Teilplatten ermöglicht ist. Soweit die für den Anwendungsfall "Verpressen von Leiterplatten" erwünschte konvexe Form der Heizplatte erreicht ist, geht das Spiel der eingesetzten Verbinder gegen Null, so dass sie dann als Sicherung gegen ein weiteres Verformen fungieren und im Zusammenspiel mit dem herrschenden Flüssigkeitsdruck exakt die gewünschte konvexe Verformung der Heizplatte sicherstellen. Dies erfolgt, wie oben bereits erwähnt, durch reinen Formschluss und ohne die Gefahr; dass Thermoflüssigkeit aus der Trennebene der Heizplatte an den Verbindern entlang nach außen dringen kann.

Ein Ausführungsbeispiel für eine Heizplatte nach der vorliegenden Erfindung und mehrere Ausführungsbeispiele für im Rahmen der Erfindung verwendete Verbinder werden im Folgenden anhand der beigefügten Zeichnungen näher beschrieben und erläutert. Es zeigen:
- Figur 1: eine schematische seitliche Schnittdarstellung einer Heizplatte nach der Erfindung, bestehend aus zwei Teilplatten;
- Figur 2: die obere Teilplatte aus Figur 1 in einer Draufsicht von unten;
- Figur 3: die untere Teilplatte aus Figur 1 in einer Draufsicht von oben;
- Figur 4: einen Teilschnitt entlang der Linie A-A aus Figur 2;
- Figur 5: unterschiedliche Querschnittsformen von Verbindern.

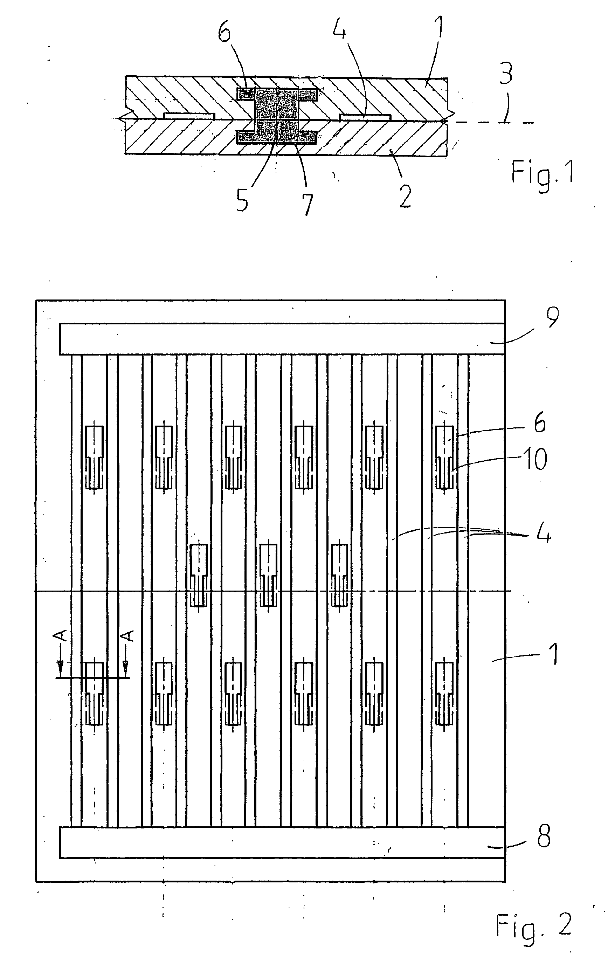

In Figur 1 ist ein Teil einer erfindungsgemäß ausgebildeten Heizplatte in einer seitlichen Schnittdarstellung gezeigt. Die Heizplatte besteht aus einer oberen Teilplatte 1 und einer unteren Teilplatte 2 mit einer dazwischen liegenden Trennebene 3. In der Trennebene befinden sich Kanäle 4 zur Durchleitung eines Fluids, hier eines Thermoöls. Wie aus Figur 1 ersichtlich, sind die Kanäle 4 als offene Kanäle in die obere Teilplatte 1 eingefräst worden, bevor die beiden Teilplatten 1, 2 aufeinandergelegt und miteinander verbunden wurden. Durch das Aufeinanderlegen der beiden Teilplatten 1, 2 sind die Kanäle 4 geschlossen worden. Diese Vorgehensweise bei der Herstellung der Heizplatte mit innenliegenden Kanälen 4 bringt erhebliche Kostenvorteile gegenüber einer Herstellung der Kanäle 4 mittels Langlochbohrungen und ermöglicht einen wesentlich dünneren Aufbau der aus den Teilplatten 1, 2 bestehenden Heizplatte. Wenn die Teilplatten 1, 2 lediglich im Randbereich der Heizplatte stoffschlüssig miteinander verbunden sind, etwa durch Verschweißen, werden abhängig vom Pumpendruck des Thermoöl-Kreislaufs die obere Teilplatte 1 und die untere Teilplatte 2 an den Kanälen 4 etwas auseinandergedrückt, wodurch sich ein Spalt in der Trennebene 3 an den Seitenwänden der Kanäle 4 öffnet. Das Thermoöl dringt in diesen Spalt in der Trennebene 3 ein, wodurch sich die Flächenkraft bei gleichbleibendem Pumpendruck aufgrund der großflächigen Verteilung des Thermoöls in der Trennebene 3 in Richtung der Normalen der Trennebene 3 stark vergrößert, so dass die obere Teilplatte 1 und die untere Teilplatte 2 weiter auseinandergedrückt werden.

Um diesem Vorgang zu begegnen, zeigt Figur 1 in der dargestellten Heizplatte außerdem einen erfindungsgemäßen Verbinder 5 in Doppel-T-Form, der in einer hinterschnittenen Nut 6 in der oberen Teilplatte 1 sowie in einer entsprechend hinterschnittenen Nut 7 in der unteren Teilplatte 2 sitzt und aufgrund der Hinterschnitte die obere Teilplatte 1 und die untere Teilplatte 2 gegen eine Aufspreizung durch das Thermoöl zusammenhält.

Wie Figur 1 ferner verdeutlicht, sind die Nuten 6, 7 in den Teilplatten 1, 2 von der Trennebene 3 her eingebracht, so dass hierdurch keinerlei Verbindung zwischen der Trennebene 3 und der Umgebung der Heizplatte hergestellt wird. Ein Dichtheitsproblem hinsichtlich des in den Kanälen 4 fließenden und auch entlang der Trennebene 3 sich bewegenden Fluids gibt es mit dem erfindungsgemäßen Verbinder 5 also nicht.

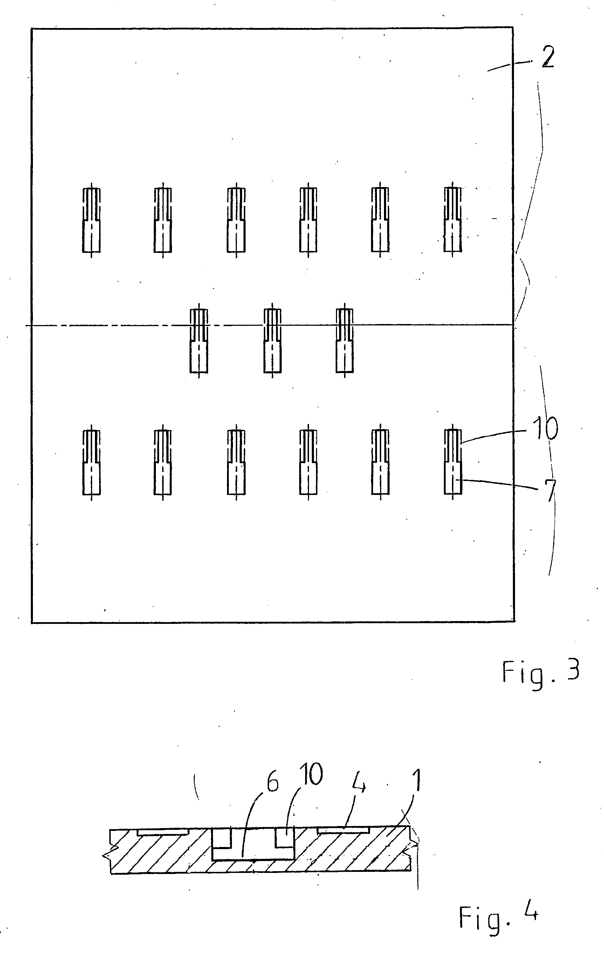

Figur 2 zeigt die obere Teilplatte 1 in einer Ansicht von unten, während Figur 3 die untere Teilplatte 2 in einer Draufsicht zeigt. Beide Teilplatten 1, 2 sind also von der Trennebene 3 her dargestellt.

Die in Figur 2 gezeigte obere Teilplatte 1 ist mit den Kanälen 4 und einem Vorlaufkanal 8 sowie einem Rücklaufkanal 9 versehen, in welche die Kanäle 4 jeweils münden. Diese Kanäle 4, 8, 9 sind aus der oberen Teilplatte 1 herausgefräst. Zwischen den Kanälen 4 ist eine Anzahl von Nuten 6 in die obere Teilplatte 1 eingebracht, wobei diese Nuten 6 zur Hälfte offen und zur Hälfte mit Hinterschneidungen 10 versehen sind. Der Verbinder 5 (in Figur 1 dargestellt) kann in die offene Seite der Nut 6 eingesetzt und innerhalb der Nut 6 so verschoben werden, bis er die Hinterschneidungen 10 hintergreift.

In Figur 3 sind die Gegenstücke zu den Nuten 6 aus Figur 2, nämlich Nuten 7 in gleicher Zahl sichtbar, welche ebenso wie die Nuten 6 in der oberen Teilplatte 1 teilweise offen ausgebildet und teilweise mit Hinterscheidungen 10 versehen sind. Auch hier kann in jede der Nuten 7 ein Verbinder 5 an der offenen Seite der Nut 7 eingesetzt und innerhalb der Nut 7 verschoben werden, bis er die Hinterschneidungen 10 hintergreift. Wie anhand der Darstellung ersichtlich ist, sind die Nuten 7 in der unteren Teilplatte 2 in Längsrichtung umgekehrt orientiert gegenüber den Nuten 6 in der oberen Teilplatte 1. Die Teilplatten 1, 2 werden dann etwas versetzt aufeinandergelegt, so dass die offenen Seiten der Nuten 6 und der Nuten 7 übereinander zu liegen kommen. Dementsprechend können die in den Nuten sitzenden Verbinder 5 das Aufeinanderlegen der beiden Teilplatten 1, 2 nicht behindern. Durch ein Gegeneinander-Verschieben der beiden Teilplatten 1, 2 werden die Verbinder 5 dann in den Nuten 6 bzw. 7 so verschoben, dass sie jeweils die Hinterschneidungen 10 hintergreifen und dementsprechend die obere Teilplatte 1 und die untere Teilplatte 2 aneinander formschlüssig festlegen. Wie weiter oben erwähnt, kann dieser Formschluss spielbehaftet sein, so dass die Verbinder 5 dann lediglich noch als Sicherung dienen, und nicht als primäres formschlüssiges Befestigungsmittel.

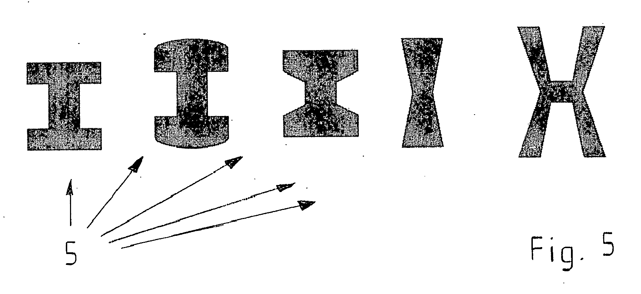

Figur 4, ein Teilschnitt entlang der Linie A-A aus Figur 2 verdeutlicht die Dimensionen der Nut 6 und der Hinterscheidungen 10, die vorliegend für einen Passsitz der Verbinder 5 ohne Spiel in der Flächennormalen ausgebildet sind.

In Figur 5 sind fünf unterschiedliche, im Rahmen der Erfindung liegende Beispiele für mögliche Querschnittsformen von Verbindern 5 dargestellt. Die hierbei verwendeten Grundformen, eine Doppel-T-Form und eine Doppel-Schwalbenschwanz-Form können selbstverständlich weiter variiert werden. Auch eine Kombination untereinander ist denkbar; die Verbinder 5 müssen nicht symmetrisch ausgebildet sein.

Abschließend soll nochmals erwähnt werden, dass die erfindungsgemäßen Heizplatten nicht nur zur Übertragung von Wärme, sondern auch zur Übertragung von Kälte verwendet und dementsprechend als "Kühlplatten" in Kaltpressen eingesetzt werden können, ohne den Rahmen der Erfindung zu verlassen.

## Patentansprüche

1. Heizplatte für eine Plattenpresse zum flächigen Verpressen von tafelförmigen Werkstücken mittels Druck und Wärme, bestehend aus mindestens zwei, an einer im Wesentlichen parallel zur Heizplattenebene verlaufenden Trennebene (3) fest miteinander verbundenen Teilplatten (1, 2), wobei im Inneren der Heizplatte eine Anzahl von Kanälen (4) vorgesehen ist, die entlang der Trennebene (3) zwischen den Teilplatten (1, 2) verlaufen und mit einem jeweils nach außen führenden Vorlaufkanal (8) sowie einem Rücklaufkanal (9) verbunden sind,
**dadurch gekennzeichnet,**
**dass** die Teilplatten (1,2) an ihren an die Trennebene (3) angrenzenden Oberflächen jeweils mit einer Anzahl von teilweise hinterschnittenen Nuten (6, 7) versehen sind, in welche jeweils mindestens ein Verbinder (5) eingesetzt ist, der den Hinterschneidungen (10) der Nuten (6, 7) entsprechende Verbreiterungen zum Hintergreifen der Hinterschneidungen (10) aufweist.

2. Heizplatte nach Anspruch 1,
**dadurch gekennzeichnet,**
**dass** die Verbinder (5) zumindest zum Teil klemmend in den Nuten (6, 7) sitzen.

3. Heizplatte nach Anspruch 1,
**dadurch gekennzeichnet,**
**dass** die Verbinder (5) mit einem im Wesentlichen senkrecht zur Heizplattenebene wirksamen Spiel in den Nuten (6, 7) sitzen.

4. Heizplatte nach mindestens einem der Ansprüche 1 bis 3,
**dadurch gekennzeichnet,**
**dass** die Verbinder aus demselben Material wie die Teilplatten (1, 2), insbesondere aus Stahl gefertigt sind.

5. Heizplatte nach mindestens einem der Ansprüche 1 bis 4,
**dadurch gekennzeichnet,**
**dass** die Verbinder (5) im Querschnitt eine Doppel-T-Form oder eine doppelte Schwalbenschwanzform aufweisen.

6. Heizplatte nach mindestens einem der Ansprüche 1 bis 5,
**dadurch gekennzeichnet,**
**dass** die Verbinder (5) mit unterschiedlichem, in der Heizplattennormalen wirksamen Spiel eingesetzt sind, derart, dass im Randbereich der Heizplatte kaum Spiel vorhanden ist, während zum Zentrum der Heizplatte hin das Spiel jeweils größer wird, um eine konvexe Verformung der beiden beteiligten Teilplatten (1, 2) zuzulassen.

## Geänderte Patentansprüche

### Geänderte Patentansprüche gemäss Regel 86(2) EPÜ.

**1.** Heizplatte für eine Plattenpresse zum flächigen Verpressen von tafelförmigen Werkstücken mittels Druck und Wärme, bestehend aus mindestens zwei, an einer im Wesentlichen parallel zur Heizplattenebene verlaufenden Trennebene (3) fest miteinander verbundenen Teilplatten (1, 2), wobei im Inneren der Heizplatte eine Anzahl von Kanälen (4) vorgesehen ist, die entlang der Trennebene (3) zwischen den Teilplatten (1, 2) verlaufen und mit einem jeweils nach außen führenden Vorlaufkanal (8) sowie einem Rücklaufkanal (9) verbunden sind,
**dadurch gekennzeichnet,**
**dass** die Teilplatten (1,2) an ihren an die Trennebene (3) angrenzenden Oberflächen jeweils mit einer Anzahl von teilweise hinterschnittenen Nuten (6, 7) versehen sind, in welche jeweils mindestens ein separater Verbinder (5) eingesetzt ist, der den Hinterschneidungen (10) der Nuten (6, 7) entsprechende Verbreiterungen zum Hintergreifen der Hinterschneidungen (10) aufweist.

**2.** Heizplatte nach Anspruch 1,
**dadurch gekennzeichnet,**
**dass** die Verbinder (5) zumindest zum Teil klemmend in den Nuten (6, 7) sitzen.

**3.** Heizplatte nach Anspruch 1,
**dadurch gekennzeichnet,**
**dass** die Verbinder (5) mit einem im Wesentlichen senkrecht zur Heizplattenebene wirksamen Spiel in den Nuten (6, 7) sitzen.

**4.** Heizplatte nach mindestens einem der Ansprüche 1 bis 3,
**dadurch gekennzeichnet,**
**dass** die Verbinder aus demselben Material wie die Teilplatten (1, 2), insbesondere aus Stahl gefertigt sind.

**5.** Heizplatte nach mindestens einem der Ansprüche 1 bis 4,
**dadurch gekennzeichnet,**
**dass** die Verbinder (5) im Querschnitt eine Doppel-T-Form oder eine doppelte Schwalbenschwanzform aufweisen.

**6.** Heizplatte nach mindestens einem der Ansprüche 1 bis 5,
**dadurch gekennzeichnet,**
**dass** die Verbinder (5) mit unterschiedlichem, in der Heizplattennormalen wirksamen Spiel eingesetzt sind, derart, dass im Randbereich der Heizplatte kaum Spiel vorhanden ist, während zum Zentrum der Heizplatte hin das Spiel jeweils größer wird, um eine konvexe Verformung der beiden beteiligten Teilplatten (1, 2) zuzulassen.
